# EUROPÄISCHE PATENTSCHRIFT

(11) **EP 1 769 509 B1**
(45) Veröffentlichungstag und Bekanntmachung des Hinweises auf die Patenterteilung: **15.04.2009**
(21) Anmeldenummer: 05752814.3
(22) Anmeldetag: 14.06.2005
(51) Int. Cl.: G11C 16/34

(54) **ELEKTRONISCHES GERÄT MIT EINEM NICHT FLÜCHTIGEN BESCHREIBBAREN DATENSPEICHER**
ELECTRONIC DEVICE PROVIDED WITH A NON-VOLATILE DATA RECORDABLE MEMORY
APPAREIL ELECTRONIQUE A MEMOIRE DE DONNEES INSCRIPTIBLE NON VOLATILE

(30) Priorität: 13.07.2004 DE 102004034042
(43) Veröffentlichungstag der Anmeldung: 04.04.2007
(73) Patentinhaber: Endress + Hauser GmbH + Co. KG, 79689 Maulburg (DE)
(72) Erfinder: PHILIPPS, Michael, 79689 Maulburg (DE)
(74) Vertreter: Andres, Angelika Maria
(86) Internationale Anmeldenummer: PCT/EP2005/052726
(87) Internationale Veröffentlichungsnummer: WO 2006/005661

(56) Entgegenhaltungen:
- EP-A- 0 492 106
- EP-A- 0 905 711
- GB-A- 2 297 403
- US-B1- 6 249 838

## Beschreibung

Die Erfindung betrifft ein elektronisches Gerät mit einem nicht flüchtigen beschreibbaren Datenspeicher, z.B. einem EEPROM, insbesondere ein Feldgerät mit einer Feldgeräte-Elektronik und einem beschreibbaren Datenspeicher. Der Stand der Technik und die Erfindung werden nachfolgend am Beispiel von Feldgeräten erläutert, wobei die Erfindung nicht auf Feldgeräte beschränkt ist.

In der Prozessautomatisierungstechnik werden zur Erzeugung von analogen oder digitalen, physikalischen oder chemischen Prozessmessgrößen repräsentierenden Messsignalen bevorzugt Feldgeräte eingesetzt.

Üblicherweise sind derartige Feldgeräte über ein entsprechendes Datenübertragungs-System miteinander und/oder mit entsprechenden Prozess-Leitrechnern verbunden, an das sie die Messsignale z.B. via (4 mA bis 20 mA)-Stromschleife und/ oder via digitalen Daten-Bus senden. Als Datenübertragungs-Systeme dienen, insb. serielle, Feldbus-Systeme, wie z.B. PROFIBUS-PA, FOUNDATION FIELDBUS, CAN-BUS etc. sowie die entsprechenden Übertragungs-Protokolle.

Mittels der Prozess-Leitrechner werden die übertragenen Messsignale weiterverarbeitet und als entsprechende Messergebnisse z.B. auf Monitoren visualisiert und/ oder in Steuersignale für Prozess-Stellglieder, wie z.B. Magnet-Ventile, Elektro-Motoren etc., umgewandelt.

Neben der primären Funktion, nämlich der Erzeugung von Messsignalen, können moderne Feldgeräte zahlreiche weitere Funktionalitäten aufweisen, die ein effizientes und sicheres Führen des zu beobachtenden Prozesses unterstützen. Dazu zählen u.a. solche zusätzlichen Funktionen, wie die Eigenüberwachung des Feldgerätes, das Abspeichern von Messwerten, das Erzeugen von Steuersignalen für Stellglieder, etc. Aufgrund dieser hohen Funktionalität der Feldgeräte können in zunehmendem

Maße Prozess leitende Funktionen in die Feld-Ebene verlagert und somit die Prozessführungs-Systeme entsprechend dezentral organisiert werden. Ferner können diese zusätzlichen Funktionalitäten z.B. auch die Inbetriebnahme des Feldgerätes sowie dessen Anbindung an das Datenübertragungs-System betreffen.

Diese obigen und ggf. weitere Funktionen der Feldgeräten sind üblicherweise mittels einer Feldgeräte-Elektronik realisiert, die einen Mikroprozessor und in diesen entsprechend implementierte Software umfasst. Die Software wird vor oder während der Inbetriebnahme des Feldgerätes in einen permanenten Speicher, z.B. einen ROM einprogrammiert und werden für den Betrieb des Feldgerätes in einen flüchtigen Speicher, z.B. einen RAM, geladen.

In einem nicht flüchtigen beschreibbaren Speicher, z.B. einem EEPROM können weiterhin Gerätedaten, wie Anwendungsdaten, Kompensationskoeffizienten, Kalibrierdaten, Fehlermeldungen und andere Statusparameter, abgelegt sein oder periodisch bzw. Ereignis gesteuert geschrieben werden, zudem können Prozessdaten, beispielsweise in Form einer Schleppzeigerfunktion, periodisch oder Ereignis gesteuert geschrieben werden.

Hierbei kann es sich als Problem erweisen, dass die Anzahl der Schreibzugriffe für einen EEPROM begrenzt sind. Beispielsweise ist der 16 Kbit EEPROM des Typs 24C164 der Firma ATMEL mit 1 Mio Schreibzugriffen pro Zelle, spezifiziert. Daraus ergibt sich unter normalen Betriebsbedingungen mit einem Schreibzugriff in ca. fünf Minuten eine Lebensdauer von etwa 10 Jahren. Unter besonderen Umständen kann die Frequenz der Schreibzugriffe in einem solchen Maße erhöht werden, dass die Lebensdauer der EEPROMs erheblich abnimmt. Dies kann im Extremfall zu einem unerwarteten Geräteausfall führen.

U.S. Patent Nr. 6,249,838, die Grundlage für die zweiteilige Form des Anspruchs 5, offenbart eine Datenspeichereinheit, beispielsweise einen so genannten Flash-Datenspeicher oder einen RAM-Speicher, welche mit Information darüber versorgt werden, wie lange ihre Restlebenszeit noch ist. Hierzu weist beispielsweise ein Flash-Datenspeicher einen Zähler auf, der mit der Zahl der maximal zulässigen vollständigen Löschungen des Datenspeichers initialisiert wird, und bei jeder Löschung den Zählerstand um eins herabsetzt. Entsprechende Warnungen können ausgegeben werden, wenn sich der Zählerstand Null nähert.

Der Zeitpunkt, wann mit einem Ausfall zu rechnen ist, ist aber mit der beschriebenen Vorgehensweise nicht zu bestimmen.

Die Aufgabe wird erfindungsgemäß gelöst durch das elektronische Gerät gemäß des unabhängigen Patentanspruchs 1.

Das erfindungsgemäße elektronische Gerät mit einem Mikroprozessor und einem nicht flüchtigen beschreibbaren Datenspeicher, welcher für eine vorgegebene maximale Schreibzugriffzahl MSZ von Schreibzugriffen beschreibbar ist; wobei das Gerät einen Zähler umfasst, welcher die Schreibzugriffe registriert, und der Mikroprozessor in Abhängigkeit der Entwicklung der Zahl der Schreibzugriffe und ggf. der maximalen Schreibzugriffzahl MSZ ein Alarmsignal generiert
wobei der Mikroprozessor ein Alarmsignal generiet, wenn die Differenz zwischen der maximalen Schreibzugriffzahl MSZ und der aktuellen Zahl der Schreibzugriffe einen Grenzwert unterschreitet, wobei dieser Grenzwert eine Funktion der Differenz zwischen der maximalen Schreibzugriffzahl MSZ und der aktuellen Zahl der Schreibzugriffe sowie der mittleren Anzahl der Schreibzugriffe pro Zeiteinheit bzw. des mittleren zeitlichen Abstands zwischen zwei Schreibzugriffen ist. Hierbei kann die mittlere Anzahl der Schreibzugriffe pro Zeiteinheit bzw. der mittlere zeitliche Abstand zwischen zwei Schreibzugriffen beispielsweise als kumulierter oder gleitender Mittelwert bestimmt werden.

Nach einem zweiten Gesichtspunkt der Erfindung kann der Mikroprozessor ein Alarmsignal generieren, wenn die anhand der zeitlichen Entwicklung der Zahl der Schreibzugriffe und der maximalen Schreibzugriffzahl ermittelte verbleibende Lebensdauer des nicht flüchtigen beschreibbaren Datenspeichers, eine Mindestzeit unterschreitet. Die Mindestzeit kann beispielsweise ein vorgegebener oder vom Anwender vorgebbarer Wert sein.

Nach einem dritten Gesichtspunkt der Erfindung kann der Mikroprozessor ein Alarmsignal generieren, wenn die mittlere Anzahl der Schreibzugriffe pro Zeiteinheit einen Maximalrate überschreitet, bzw. der mittlere zeitliche Abstand zwischen zwei Schreibzugriffen eine Mindestzeit unterschreitet. Die Maximalrate oder die Mindestzeit können jeweils entweder ein fest vorgegebener oder vom Anwender vorgebbarer Wert sein, oder eine Funktion der Differenz zwischen der maximalen Schreibzugriffzahl MSZ und der aktuellen Zahl der Schreibzugriffe.

In der derzeit bevorzugten Ausgestaltung der Erfindung umfasst der nicht flüchtige beschreibbare Datenspeicher ein EEPROM.

Insoweit, als die Zahl der Schreibzugriffe vorzugsweise auch nach einem vorübergehenden Geräteausfall bzw. Ausfall der Energieversorgung zur Verfügung stehen soll, ist es ratsam, dass die aktuelle Zahl der Schreibzugriffe in dem nicht flüchtigen Speicher, beispielsweise dem EEPROM, abgelegt wird.

Zudem können die Zugriffszeiten ausgewählter Schreibzugriffe zur Ermittlung der Zugriffsraten in einem RAM oder im EEPROM abgespeichert werden.

Der Zähler der Schreibzugriffe kann zweckmäßig in den Mikroprozessor integriert sein.

In einer Weiterbildung der Erfindung umfasst das elektronische Gerät ein Feldgerät zum Erfassen einer chemischen oder physikalischen Prozessmessgröße, oder zum Steuern eines Aktors, wie eines Ventilantriebs, oder einer Pumpe. Physikalische oder chemische Prozessmessgrößen sind beispielsweise Volumen- oder Massendurchfluss, Füllstand, Druck, Temperatur, Feuchte, analytische Parameter, wie pH-Wert oder andere potentiometrische Größen, Sauerstoffgehalt, Nitratgehalt, Trübung, Gaskonzentration. Die Liste der Prozessmessgrößen ist lediglich erläuternd und keinesfalls beschränkend zu verstehen.

Das erfindungsgemäße Feldgerät kann insbesondere ein Feldgerät mit digitaler Kommunikation sein, welches eine Kommunikationsschnittstelle aufweist, über welche der Mikroprozessor mit einem Feldbus verbunden ist. Ein Feldbus kann beispielsweise ein PROFIBUS-PA, ein FOUNDATION FIELDBUS oder ein CAN-BUS sein.

Gerade externe Zugriffe auf das Feldgerät über den Feldbus können einen erheblichen Anstieg der Schreibzugriffe auf den nicht flüchtigen beschreibbaren Speicher bewirken, wodurch die erfindungsgemäße Alarmierung im Sinne einer vorausschauenden Überwachung erforderlich wird.

In einer Weiterbildung wird berücksichtigt, dass ein EEPROM eine Vielzahl von Zellen umfasst, beispielsweise 2000. Die Lebensdauer ist insbesondere dann stark beschränkt, wenn die Schreibzugriffe immer wieder auf die gleichen Zellen erfolgen.

Schreibzugriffe auf unterschiedliche Zellen bewirken dagegen weniger starke Beeinträchtigungen. Für den Fall dass in einer bestimmten Anwendung nicht immer auf die gleichen Zellen zugegriffen wird sondern auf mehrere unterschiedliche Zellen bzw. mehrere unterschiedliche Cluster von Zellen, kann es vorteilhaft sein, mit mehreren Zählern, die jeweils einer Zelle oder einem Cluster von Zellen zugeordnet sind, die Schreibzugriffe für die einzelnen Zellen bzw. Cluster zu erfassen, und entsprechend sinngemäß zu den zuvor erläuterten Kriterien dann einen Alarm generieren zu lassen, wenn für eine Zelle bzw. ein Cluster ein entsprechender Alarmzustand erreicht wird.

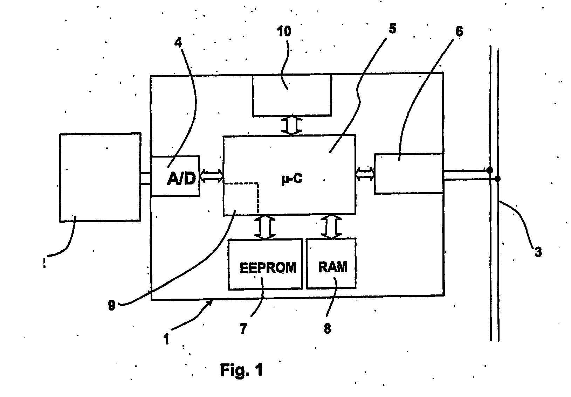

Die Erfindung wird nun anhand eines in Fig. 1 gezeigten Ausführungsbeispiels erläutert. Es zeigt:

Fig. 1: Ein Blockdiagram einer Feldgeräteelektronik eines erfindungsgemäßen Feldgerätes.

Das erfindungsgemäße Feldgerät 1 ist ein Messumformer, z.B. ein Druckmessumformer, mit einem Primärsensor 2 und ggf. einem Vorverstärker dessen Analogsignal über einen A/D-Wandler 4 einem Mikroprozessor 5 zugeführt wird. Der Mikroprozessor 5 ist weiterhin mit einer Busschnittstelle 6 verbunden, über die er mit einem Feldbus 3, beispielsweise einem Foundation Fieldbus kommuniziert.

Der Mikroprozessor ist weiterhin mit einem EEPROM 7, einem RAM 8, sowie einem nicht dargestellten ROM funktionell verbunden, Zum Betrieb des Messumformers wird das Programm des Mikroprozessors, welches im ROM abgelegt ist, in den RAM 8 geladen. Gleichermaßen werden Kompensationskoeffizienten des Drucksensors und andere Sensor- und Statusdaten aus dem EEPROM 7 ausgelesen und in den RAM 8 geschrieben. Im aktuellen Betrieb arbeitet der Prozessor mit den im RAM 8 abgelegten Kompensationsparametern sowie Sensor- und Status-Daten. Im EEPROM 7 werden in bestimmten Zeitabständen aktualisierte Mittelwerte der Messdaten über Schreibzugriffe hinterlegt. Weiterhin können beispielsweise Min- und Max-Daten sowie Fehlerereignisse und Statusdaten über Schreibzugriffe im EEPROM aktualisiert werden. weitere Schreibzugriffe auf den EEPROM 7 können über eine Anzeige und Bedieneinheit 10 oder über den Feldbus 3 veranlasst werden, beispielsweise in einem Servicemodus, wenn anwendungsspezifische Daten oder Kalibrierdaten aktualisiert werden sollen. Insbesondere bei Schreibzugriffen aus externen Veranlassungen kann es zu einer unangemessen hohen Rate von Schreibzugriffen kommen, die den EEPROM schnell altern lassen. Um hier im Sinne einer vorausschauenden Wartung rechtzeitig Warnungen auszugeben, weist der Messumformer einen Zähler 9 auf, welcher die Zahl der Schreibzugriffe registriert, und beispielsweise im EEPROM und/oder im RAM speichert. Die Rate der Schreibzugriffe lässt sich beispielsweise dadurch ermitteln, dass die Zeit eines N-ten Schreibzugriffs abgespeichert und von der Zeit des N+M-ten Schreibzugriffs abgezogen wird. Wobei M so groß zu wählen ist, dass die ermittelte Rate statistisch sinnvoll ist. M kann beispielsweise in der Größenordnung von einigen 10 bis 1000 liegen. Wenn sich eine Rate von mehr als beispielsweise 10 pro Minute ergibt, wird ein Alarm generiert und über die Kommunikationsschnittstelle ausgegeben. Gleichermaßen wird ein Alarm generiert, wenn anhand der aktuellen Schreibzugriffszahl und der mittleren Schreibzugriffsrate folgt, dass die maximale Schreibzugriffszahl MSZ in weniger als einem Monat überschritten wird.

## Patentansprüche

1. Elektronisches Gerät (1) mit einem Mikroprozessor (5) und; einem nicht flüchtigen beschreibbaren Datenspeicher (7), welcher für eine vorgegebene maximale Schreibzugriffzahl MSZ von Schreibzugriffen beschreibbar ist;
wobei das Gerät mindestens einen Zähler (9) umfasst, welcher eine aktuelle Zahl der Schreibzugriffe registriert, wobei
der Mikroprozessor (5) in Abhängigkeit der Entwicklung der aktuellen Zahl der Schreibzugriffe ein Alarmsignal erzeugt, wobei der Mikroprozessor (5) das Alarmsignal generiert, wenn die Differenz zwischen der maximalen Schreibzugriffzahl MSZ und der aktuellen Zahl der Schreibzugriffe einen Grenzwert unterschreitet, **dadurch gekennzeichnet, dass**
der Grenzwert eine Funktion der Differenz zwischen der maximalen Schreibzugriffzahl MSZ und der aktuellen Zahl der Schreibzugriffe sowie der mittleren Anzahl der Schreibzugriffe pro Zeiteinheit bzw. des mittleren zeitlichen Abstands zwischen zwei Schreibzugriffen ist.

2. Elektronisches Gerät (1) nach Anspruch 1, wobei die mittlere Anzahl der Schreibzugriffe pro Zeiteinheit bzw. der mittlere zeitliche Abstand zwischen zwei Schreibzugriffen als kumulierter oder gleitender Mittelwert bestimmt wird.

3. Elektronisches Gerät (1) nach einem der vorhergehenden Ansprüche, wobei der Mikroprozessor (5) ein Alarmsignal generiert, wenn die anhand der zeitlichen Entwicklung der Zahl der Schreibzugriffe und der maximalen Schreibzugriffzahl ermittelte verbleibende Lebensdauer des nicht flüchtigen beschreibbaren Datenspeichers, eine Mindestzeit unterschreitet.

4. Elektronisches Gerät (1) nach Anspruch 3, wobei die Mindestzeit ein vorgegebener oder vorgebbarer Wert ist.

5. Elektronisches Gerät (1) nach einem der vorhergehenden Ansprüche, wobei der Mikroprozessor (5) ein Alarmsignal generiert, wenn die mittlere Anzahl der Schreibzugriffe pro Zeiteinheit eine Maximalrate überschreitet, bzw. der mittlere zeitliche Abstand zwischen zwei Schreibzugriffen eine Mindestzeit unterschreitet.

6. Elektronisches Gerät (1) nach Anspruch 5, wobei die Maximalerate oder die Mindestzeit ein fest vorgegebener oder vorgebbarer Wert ist.

7. Elektronisches Gerät (1) nach Anspruch 5, wobei die Maximalerate oder die Mindestzeit eine Funktion der Differenz zwischen der maximalen Schrelbzugriffzahl MSZ und der aktuellen Zahl der Schreibzugriffe ist.

8. Elektronisches Gerät (1) nach Anspruch 7, wobei der nicht flüchtige beschreibbare Datenspeicher (7) ein EEPROM umfasst.

9. Elektronisches Gerät (1) nach Anspruch 8, wobei die aktuelle Zahl der Schreibzugriffe und/oder die Zeit von ausgewählten Schreibzugriffen in einem RAM oder im EEPROM abgelegt werden.

10. Elektronisches Gerät (1) nach einem der vorhergehenden Ansprüche wobei der Zähler (9) in den Mikroprozessor (5) integriert ist.

11. Elektronisches Gerät (1) nach einem der vorhergehenden Ansprüche, wobei das elektronische Gerät ein Feldgerät zum Erfassen einer chemischen oder physikalischen Prozessmessgröße oder zum Steuern eines Aktors ist.

12. Feldgerät (1) nach Anspruch 11, weiterhin umfassend eine Kommunikationsschnittstelle, über welche der Mikroprozessor (5) mit einem Feldbus (3) verbunden ist.

13. Feldgerät (1) nach Anspruch 12, wobei die Mehrheit der Schreibzugriffe auf den EEPROM (7) durch über den Feldbus (3) übertragene Signale veranlasst sind.

14. Feldgerät (1) nach einem der Ansprüche 11 bis 13, **dadurch gekennzeichnet, dass** der Datenspeicher mindestens zwei Zellen bzw. Cluster von Zellen aufweist, und das Gerät eine entsprechende Anzahl von Zählern umfasst, welche jeweils den Zellen bzw. Clustern zugeordnet sind und die jeweiligen Schreibzugriffe registrieren, wobei der Mikroprozessor (5) in Abhängigkeit der Entwicklung der Zahl der Schreibzugriffe auf die einzelnen Zellen bzw. Cluster ein Alarmsignal generiert.

## Claims

1. Electronic device (1) with a microprocessor (5) and a writable data memory (7), which is non-volatile, and can be written to for a specified maximum number of writes (MSZ);
**characterized in that** the device comprises at least one counter (9) which records the current number of writes, where
the microprocessor (5) generates an alarm signal depending on the development of the current number of writes and where the microprocessor generates the alarm signal when the difference between the maximum number of writes (MSZ) and the current number of writes drops below a limit value, **characterized in that**
the limit value is a function of the difference between the maximum number of writes (MSZ) and the current number of writes, as well as the average number of writes per time unit or the average interval between two writes.

2. Electronic device (1) as per Claim 1, where the average number of writes per time unit, or the average interval between two writes is determined as a cumulative or moving average.

3. Electronic device (1) as per one of the previous claims, where the microprocessor (5) generates an alarm signal when the remaining operating life of the writable, non-volatile data memory drops below a minimum time, said operating life being determined using the development over time of the number of writes and the maximum number of writes.

4. Electronic device (1) as per Claim 3, where the minimum time is a prespecified or prespecifiable value.

5. Electronic device (1) as per one of the previous claims, where the microprocessor (5) generates an alarm signal when the average number of writes per time unit exceeds a maximum rate, or the average interval over time between two writes drops below a minimum time.

6. Electronic device (1) as per Claim 5, where the maximum rate or the minimum time is a permanently specified or specifiable value.

7. Electronic device (1) as per Claim 5, where the maximum rate or the minimum time is a function of the difference between the maximum number of writes (MSZ) and the current number of writes.

8. Electronic device (1) as per Claim 7, where the non-volatile data memory (7) comprises an EEPROM.

9. Electronic device (1) as per Claim 8, where the current number of writes and/or the time of selected writes are stored in a RAM or in the EEPROM.

10. Electronic device (1) as per one of the previous claims where the counter (9) is integrated in the microprocessor (5).

11. Electronic device (1) as per one of the previous claims, where the electronic device is a field device for recording a chemical or physical process measured variable, or for controlling an actuator.

12. Field device (1) as per Claim 11, further comprising a communication interface via which the microprocessor (5) is connected to a fieldbus (3).

13. Field device (1) as per Claim 12, where the majority of the writes to the EEPROM (7) is initiated by signals transmitted via the fieldbus (3).

14. Field device (1) as per one of the Claims 11 to 13, **characterized in that** the data memory exhibits at least two cells, or clusters of cells, and the device comprises an appropriate number of counters which are each assigned to the cells or clusters and record the particular writes, whereby the microprocessor (5) generates an alarm signal depending on the development of the number of writes to the individual cells or clusters.

## Revendications

1. Appareil électronique (1) doté d'un microprocesseur (5) et d'une mémoire de données (7) inscriptible, non volatile, laquelle autorise un nombre maximal MSZ prédéfini d'accès en écriture ;
l'appareil comprenant au moins un compteur (9), qui enregistre un nombre actuel d'accès en écriture,
le microprocesseur générant un signal d'alarme en fonction de l'évolution du nombre actuel d'accès en écriture, le microprocesseur générant le signal d'alarme lorsque la différence entre le nombre maximal d'accès en écriture et le nombre actuel d'accès en écriture parvient sous une valeur seuil, **caractérisé en ce que**
la valeur seuil est une fonction de la différence entre le nombre maximal d'accès en écriture MSZ et le nombre actuel d'accès en écriture, ainsi que du nombre moyen d'accès en écriture par unité de temps ou du temps moyen entre deux accès en écriture.

2. Appareil électronique (1) selon la revendication 1, pour lequel le nombre moyen d'accès en écriture par unité de temps ou le temps moyen entre deux accès en écriture est déterminé en tant que valeur moyenne cumulée ou mobile.

3. Appareil électronique (1) selon l'une des revendications précédentes, pour lequel le microprocesseur (5) génère un signal d'alarme lorsque la durée de vie restante de la mémoire de données inscriptible, non volatile, déterminée au moyen de l'évolution dans le temps du nombre d'accès en écriture et du nombre maximal d'accès en écriture, parvient sous un temps minimum.

4. Appareil électronique (1) selon la revendication 3, pour lequel le temps minimum est une valeur prédéfinie ou prédéfinissable.

5. Appareil électronique (1) selon l'une des revendications précédentes, pour lequel le microprocesseur (5) génère un signal d'alarme lorsque le nombre moyen d'accès en écriture par unité de temps dépasse un taux maximum, ou lorsque le temps moyen entre deux accès en écriture parvient sous un temps minimum.

6. Appareil électronique (1) selon la revendication 5, pour lequel le taux maximum ou le temps minimum est une valeur prédéfinie ou prédéfinissable.

7. Appareil électronique (1) selon la revendication 5, pour lequel le taux maximum ou le temps minimum est une fonction de la différence entre le nombre maximal d'accès en écriture MSZ et le nombre actuel d'accès en écriture.

8. Appareil électronique (1) selon la revendication 7, pour lequel la mémoire de données inscriptible (7), non volatile, est une EEPROM.

9. Appareil électronique (1) selon la revendication 8, pour lequel le nombre actuel d'accès en écriture et/ou le temps d'accès en écriture sélectionnés sont enregistrés dans une RAM ou dans une EEPROM.

10. Appareil électronique (1) selon l'une des revendications précédentes, pour lequel le compteur (9) est intégré dans le microprocesseur (5).

11. Appareil électronique (1) selon l'une des revendications précédentes, l'appareil électronique étant un appareil de terrain destiné à l'acquisition d'une grandeur mesurée chimique ou physique du process, ou destiné à la commande d'un actionneur.

12. Appareil de terrain (1) selon la revendication 11, comprenant en outre une interface de communication, par l'intermédiaire de laquelle le microprocesseur (5) est relié avec un bus de terrain (3).

13. Appareil de terrain (1) selon la revendication 12, pour lequel la plupart des accès en écriture à l'EEPROM (7) sont déclenchés par des signaux transmis via le bus de terrain (3).

14. Appareil de terrain (1) selon l'une des revendications 11 à 13, **caractérisé en ce que** la mémoire de données comporte au moins deux cellules ou groupes de cellules, et **en ce que** l'appareil comporte un nombre correspondant de compteurs, lesquels sont affectés respectivement aux cellules ou aux groupes de cellules, et enregistrent les accès en écriture respectifs, le microprocesseur (5) générant un signal d'alarme en fonction de l'évolution du nombre d'accès en écriture aux différentes cellules ou groupes de cellules.
